**Europäisches Patentamt**

**European Patent Office**

**Office européen des brevets**

(19)

(11) Publication number : **0 481 755 A2**

# (12) EUROPEAN PATENT APPLICATION

(21) Application number : **91309527.9**

(22) Date of filing : **16.10.91**

(51) Int. Cl.⁵ : **H01F 17/00, H01F 41/04**

(30) Priority : **16.10.90 US 598896**

(43) Date of publication of application :
**22.04.92 Bulletin 92/17**

(84) Designated Contracting States :
**AT BE CH DE DK ES FR GB GR IT LI LU NL SE**

(71) Applicant : **VLT CORPORATION**
**9901 I.H. 10 West, 8th Floor**
**San Antonio, Texas 78230 (US)**

(72) Inventor : **Vinciarelli, Patrizio**
**65 East India Row, no: 354**
**Boston, MA 02110 (US)**

(74) Representative : **Deans, Michael John Percy et al**
**Lloyd Wise, Tregear & CO. Norman House**
**105-109 Strand**
**London WC2R OAE (GB)**

(54) **Electromagnetic windy structures, and methods for forming electromagnetic winding structures.**

(57)   An electromagnetic component combines a fixed pattern of conductive runs and pads on one or more layers of a substrate with a configurable array of conductors which connect between the conductive runs and pads, and provides, via appropriate configuration of the conductors and the interconnections between the conductors and the fixed pattern of conductive runs and pads, a means for implementing one or more tapped and untapped electromagnetic windings where the number of turns in each winding may be selectively varied in a lot of one production mode.

FIG. 1

**EP 0 481 755 A2**

This invention relates to the general field of electromagnetic windings.

The electromagnetic windings in inductors, transformers, and other electromagnetic components have traditionally been formed by wrapping continuous strands of conductive wire on magnetic cores, or on bobbins or coil formers for placement over magnetic cores. When used in an electronic circuit, such an electromagnetic component is typically connected to a printed circuit board by inserting the terminations of its windings into plated through holes in the board, and soldering the terminations to the liners of the holes and to conductive runs on the surface of the board. Mounting the components in this way can be cumbersome and inefficient when large volumes of identical finished printed circuits are being produced.

The inefficiency is even greater for so-called "high mix" circuit designs in which electromagnetic components having the same physical configurations but different electrical characteristics are mounted on identical printed circuit boards. For example, different versions of a given power converter circuit design may be fabricated using different transformers on identical printed circuit boards. While all of the different transformers have essentially the same physical configuration (dimensions and locations of terminations), each transformer has particular primary and secondary windings whose turns are appropriate to impart desired input and output voltage characteristics to the finished circuit.

In an extreme, but practically important, production mode (called "lot of one") each printed circuit board could bear a transformer different from the transformer used on either the previous circuit board or the next circuit board on the assembly line. Stockpiling inventories of the various types of transformers and installing them manually in a high mix assembly line is inefficient.

Several techniques have been discussed for reducing the cost and improving the ease of incorporating electromagnetic components into circuit assemblies.

In one known technique for automating the formation of an electromagnetic winding on a printed circuit board, conductive runs are formed in a spiral configuration as part of the printed circuit itself. Different printed circuits must be fabricated to achieve different winding configurations.

It is known how to form an electromagnetic winding of two winding portions, by forming one portion as conductive runs on a substrate, and forming the other portion as conductors connected to the conductive runs.

For example, in Shelley, United States Patent 4,455,545, an inductor winding is formed by soldering wires into plated-through holes associated with conductive runs on a substrate. Different printed circuit patterns are formed to achieve the same current densities in the inductor for different conductor turns arrangements. In some patterns two wires are connected to a single conductive run.

In another scheme, illustrated in Meinel, United States Patents 4,777,465 and 4,847,986, an electromagnetic winding is formed by bonding wires to parallel conductive runs formed on a substrate. A similar arrangement is shown in French Patent 2,556 493.

We explain below how an electromagnetic component may combine a fixed pattern of conductive runs and pads on one or more layers of a substrate with a configurable array of conductors which connect between the conductive runs and pads, and provides, via appropriate configuration of the conductors and the interconnections between the conductors and the fixed pattern of conductive runs and pads, a means for implementing one or more tapped and untapped electromagnetic windings where the number of turns in each winding may be selectively varied in a lot of one production mode.

Thus, in general, in one aspect, the invention features an electromagnetic winding structure having a winding in which conductive runs are formed, e.g., in a fixed pattern, on a substrate to serve as one portion of the winding, and conductors are electrically connected to the conductive runs to serve as another portion of the winding. An end of at least one of the conductors is connected to at least two of the conductive runs.

Preferred embodiments include the following features. The substrate includes a printed circuit board and the runs are formed on a surface of the board. Plated-through holes are connected to the conductive runs, and at least some of the conductors are electrically connected to the conductive runs via the plated-through holes. Additional windings may be provided comprising additional conductors overlaid on the first conductors. The conductive runs are arranged in parallel on the substrate. The number of the conductive runs on the substrate is a non-prime number (e.g., the number 20), divisible by at least two integers other than one and the non-prime number itself. The substrate may be generally planar and the conductive runs may comprise two sets lying respectively on opposite sides of the substrate.

A magnetic core structure may be magnetically coupled to the winding. The magnetic core structure may include a magnetic core piece surrounded by the winding and an additional magnetic core piece which cooperates with the first magnetic core piece to form a magnetic flux circuit with one segment of the magnetic circuit lying within the winding and another segment of the magnetic circuit lying outside the winding. The magnetic flux circuit may include a predefined gap.

One of the conductors may be connected to more than two of the conductive runs. Different conductors may be connected respectively to different numbers of the conductive runs. A termination conductive run may carry current to or from the winding, and a bridge may connect one of the conductive runs to the termination conductive run. One of the conductive runs may not be connected in the winding and then the bridge may connect at least one of the conductive runs which is connected to the winding to a termination conductive run on the substrate. The bridge may connect multiple conductive runs to the termination conductive run.

A tap conductive run may carry current to or from a tap of the winding, and a bridge may connect one of the conductive runs to the tap conductive run.

The substrate is generally planar and may have more than two layers, and the conductive runs comprise more than two sets lying respectively on different layers of the substrate.

The conductors may have a cross-section which is substantially rectangular.

By connecting appropriate conductors to appropriate numbers of the conductive runs, the number of turns on inductors, and the numbers of primary and secondary turns (and hence the turns ratios) of transformers can be selectively changed for each successive electromagnetic component being produced, without changing the pattern of conductors on the substrate. By connecting the ends of one or more of the conductors to pads which are part of the fixed pattern of conductive runs, windings may be easily tapped.

In general, in another aspect, the invention features an electromagnetic winding structure having multiple turns formed by connecting conductive runs to conductors which have a generally rectangular cross-section with an aspect ratio (the ratio of the width of the conductor to its thickness) higher than 2.

The high aspect ratio is beneficial in that it provides an intrinsic capability for forming low-resistance joints between conductors and the conductive runs on the substrate. The conductors may be formed to have relatively flat connection pads with relatively large surface area, and these flat pads may then be soldered, or otherwise conductively joined, to the conductive runs using contemporary manufacturing processes (e.g., surface mount assembly and soldering techniques). The low resistance of these large area joints is especially important in power applications since the winding structure featured in the invention has two joints-per-turn.

The high aspect ratio is also naturally compatible with high frequency operation because (a) the surface area to volume ratio of the winding is high, and (b) the relatively large conductor surfaces minimize losses associated with "skin effect". In addition, the aspect ratio of the windings, combined with their planar structure, minimizes the turn-to-turn capacitance of the electromagnetic component.

In general, in other aspects, the invention comprises a transformer having two (or more) of the windings, and a free-standing, discrete structure for use in a winding.

Preferred embodiments include the following features. The flat conductors have portions which are in contact with the magnetic core piece, and free ends which are not in contact with the magnetic core piece, the free ends forming the flat connection regions. A second magnetic core piece is arranged to form, with the first the magnetic core piece, a channel in which at least portions of the flat conductors lie. The conductors comprise two or more sets of conductors, each set overlying the other. The first magnetic core piece and the second magnetic core piece form a magnetic circuit. The magnetic circuit includes a predetermined gap. The magnetic core piece is essentially U-shaped. The conductors and the magnetic circuit are electromagnetically coupled.

In general, in another aspect, the invention features a method of forming, on each one of a series of printed circuit boards, an electromagnetic component having a winding, the method comprising forming identical patterns of conductive runs on the different boards, and electrically connecting to the pattern on each of the boards, in order to form a winding, a set of conductors which in number and configuration cause the winding to have a selected number of turns, the windings of the electromagnetic components on different ones of the boards having different, selected numbers of turns.

Preferred embodiments include the following features. A pattern representing a complete set of conductors for a selected winding configuration is fabricated in "real time" from a flat conductive work piece. The flat conductive work piece comprises a metal sheet large enough to form more than one of the patterns. Supporting regions are also formed on the flat conductive work piece to hold the pattern of conductors in place. The pattern of flat conductors is attached to a magnetic core before forming the electrical connections. The supporting regions are removed (by computer controlled laser or die cutting) prior to forming the electrical connections.

In other aspects, the invention features a method of forming a free-standing, discrete electromagnetic structure for use in an electromagnetic winding, and a method of manufacturing a series of similar versions of an electrical circuit which includes an electromagnetic component with at least one winding, different versions of the electrical circuit incorporating different versions of the electromagnetic component having respectively different numbers of turns in said winding.

The methods are simple, fast, adaptable, and repeatable. A fixed "footprint" of conductive runs and pads on a printed circuit board substrate can support many different inductors or transformers. The electromagnetic components can be fabricated in "real time" and placed on boards that are in process on the assembly line. Construction of the transformers and inductors is easily automated, as is cutting and forming of conductors. The simple shapes associated with the core components and conductors are inherently low in cost, use space efficiently and are electrically efficient. The winding portion on the substrate "comes for free" since it is formed as part of the printed circuit board. Desired amounts of leakage inductance and self inductance may easily be achieved through appropriate geometric configuration of magnetic core pieces and the electromagnetic windings, gapping of the magnetic circuit formed by the core pieces, and incorporation of leakage-flux shunt paths in proximity to the windings. Both sides of a single layer printed circuit board may be used for forming one or more windings, or windings may be formed using some or all of the outer and inner layers of a multilayer printed circuit board.

Other advantages and features will become apparent from the following description of the preferred embodiment.

We first briefly describe the drawings.

Fig. 1 is a perspective view, partly in section, of a transformer formed on a printed circuit board.

Figs. 2 through 10 are plan views of various turns arrangements.

Fig. 11 is a chart of turns arrangements.

Fig. 12 is a perspective view showing a bridge.

Figs. 13 and 14 are cross-sectional views illustrating taps.

Fig. 15 is a schematic perspective view of a method of fabrication.

Figs. 16 and 17 are cross-sectional views illustrating methods of incorporating flux-shunts for adjusting the values of leakage inductances.

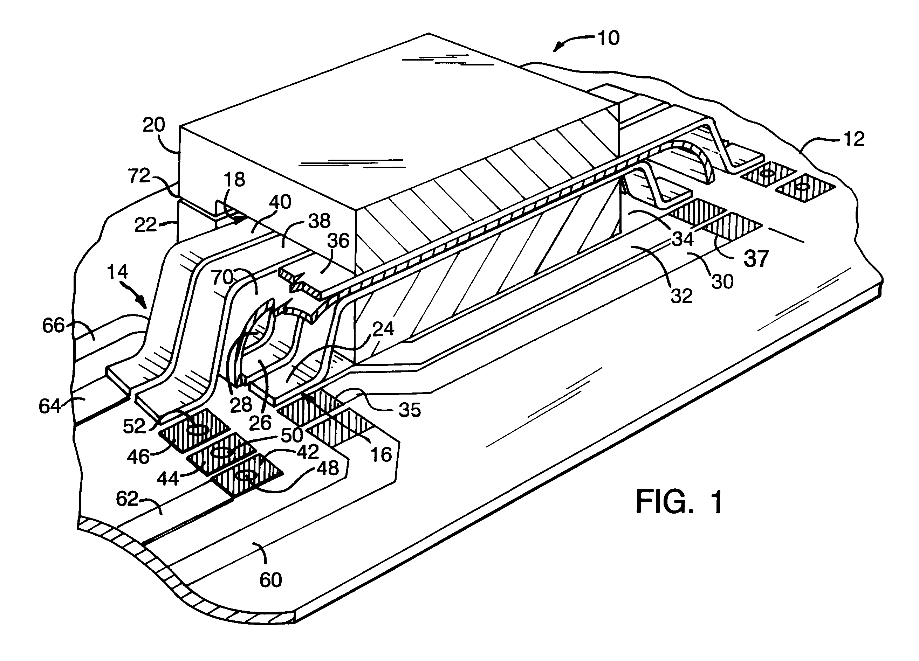

Referring to Fig. 1, a transformer 10, formed on a printed circuit board 12, includes a primary winding 14 and a secondary winding 16 which partially lie within a passageway 18 formed between two magnetic core pieces 20, 22. Secondary winding 16 includes a row of flat conductors 24, 26, 28 (some of the conductors in the row are not shown) which are electrically connected to a corresponding row of conductive runs 30, 32, 34 formed on the surface of the printed circuit board as part of the board fabrication process. The electrical connections are made at connection pads, e.g., 35, 37, which are physically no different (except in shape) from the runs. The conductors are generally rectangular in cross-section and have a relatively high aspect ratio, at least 2.

The primary winding, like the secondary winding, includes a row of flat conductors 36, 38, 40 (some not shown) connected to a corresponding row of conductive runs which are formed on the underside of printed circuit board 12 (and thus not shown in Fig. 1). The connections between the conductors and conductive runs of the primary winding are made via connection pads, e.g., 42, 44, 46, and plated-through holes, e.g., 48, 50, 52. Circuit connections to the primary and secondary windings are made via conductive runs 60, 62, 64, and 66.

A dielectric layer 70 is interposed to insulate the conductors of the primary winding from the conductors of the secondary winding.

Each core piece 20, 22 is, e.g., U-shaped and the legs of the Us meet to form a magnetic circuit with no gap or with a preselected gap 72 (as discussed in more detail below).

A simpler electromagnetic component (e.g., an inductor) can be formed using a similar configuration by eliminating the conductors 36, 38, 40, and the related conductive runs and connection pads from the printed circuit board, thus leaving a single winding with two magnetic core pieces. By also eliminating the magnetic core pieces, a simple coil can be formed.

Regardless of the particular type of electromagnetic component being formed, each winding comprises conductive runs on the printed circuit board (substrate) and conductors connected to the conductive runs. The number of turns in each winding is determined by the number of conductors used, rather than by the number of conductive runs on the printed circuit board, because any conductor may be connected either to one or to more than one conductive run. This is especially significant because a single pattern of conductive runs formed on a printed circuit board can be used as the basis for fabricating windings of a variety of numbers of turns. (And, in the case of a transformer, the turns ratio of the primary to secondary windings also can be varied by controlling the numbers of turns in each winding.)

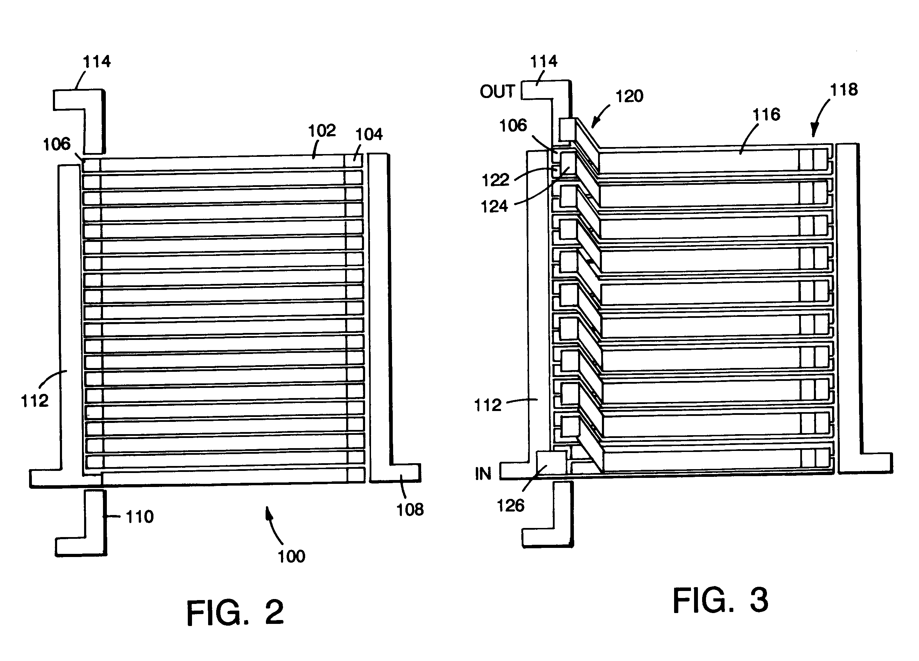

Thus, referring to Fig. 2, a fixed pattern of conductive runs 100 positioned on a printed circuit board for use in forming windings having selected numbers of turns could include a row of twenty parallel straight conductive runs 102. The ends of the conductive runs terminate in connection pads 104, 106. Each run could be, for example, 0.03 inches wide and 1.1 inches long with a separation of 0.01 inches between adjacent runs. Additional conductive runs 108, 110, 112, and 114 are provided for making connections as explained below.

Referring to Fig. 3, a 10-turn winding can be formed on the pattern of Fig. 2 by connecting a row of ten conductors 116 to the row of 20 conductive runs as follows. One end 118 of each conductor is connected to the connection pads of a first pair of adjacent conductive runs (not seen in Fig. 3). Except for the uppermost conductor in Fig. 3, the left end 122 of each conductor is connected to the connection pads 122, 124 of another pair of adjacent conductive runs. Each conductor has a jog 120 configured so that the opposite ends of the conductor are respectively connected to two different pairs of conductive runs. In this way a continuous winding is created. The uppermost conductor 116 in Fig. 3 has its left end connected to conductive run 114 to carry current out of the winding. In addition, a bridge 126 connects conductive run 112 (which provides a path for current into the winding) to the lowermost pair of conductive runs 102 in Fig. 3. The resulting winding has 10 turns.

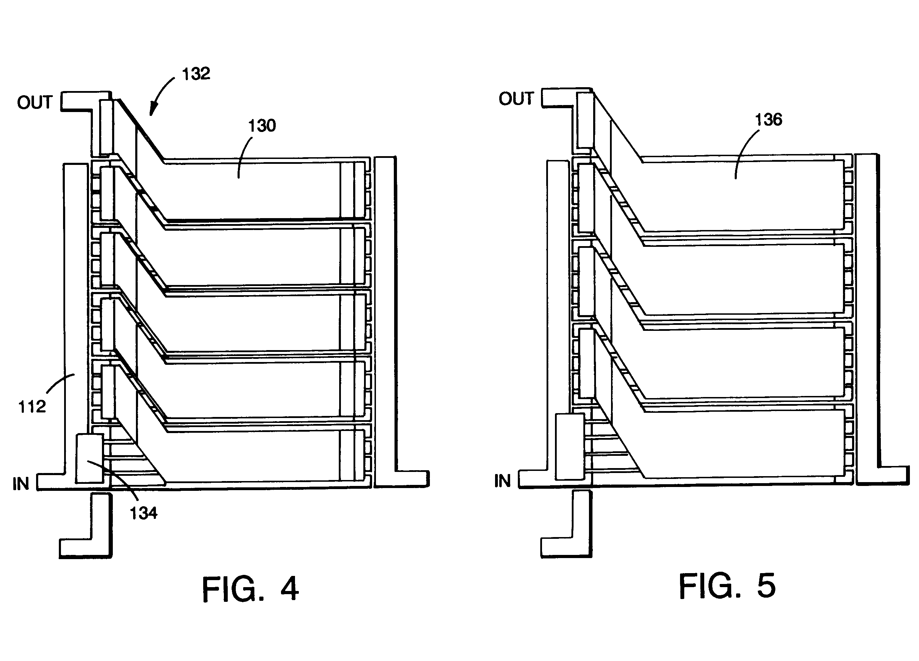

Referring to Fig. 4, the same pattern of conductive runs can be used to form a 5 turn winding by providing five conductors 130, each having a width approximately equal to the width of the space occupied by four conductive runs. The jog 132 in each conductor is configured so that the set of four conductive runs connected to one end of the conductor are different from the set of four conductive runs connected to the other end of the conductor. A bridge 134 connects the lowermost four conductive runs to the conductive run 112.

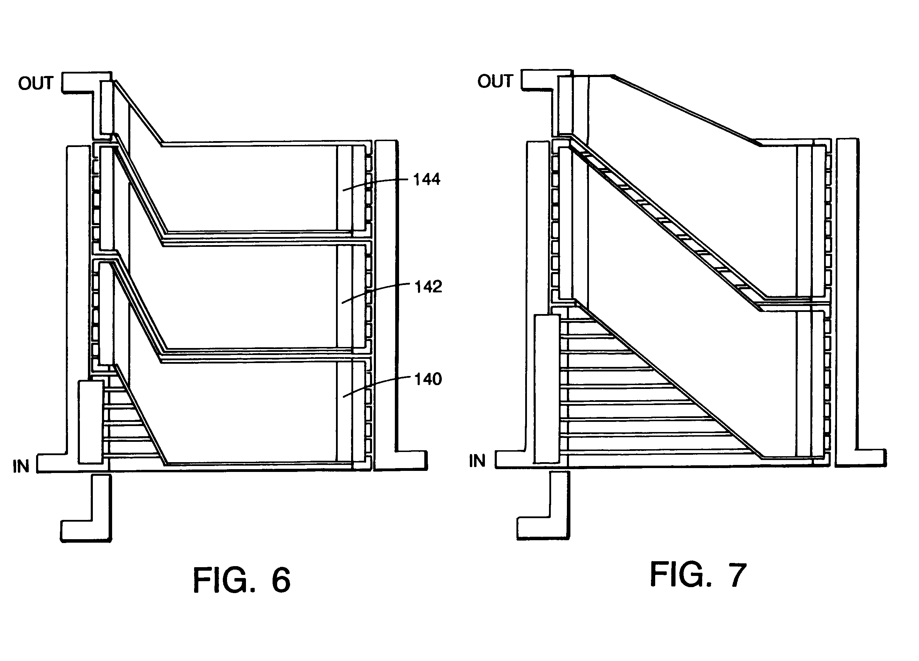

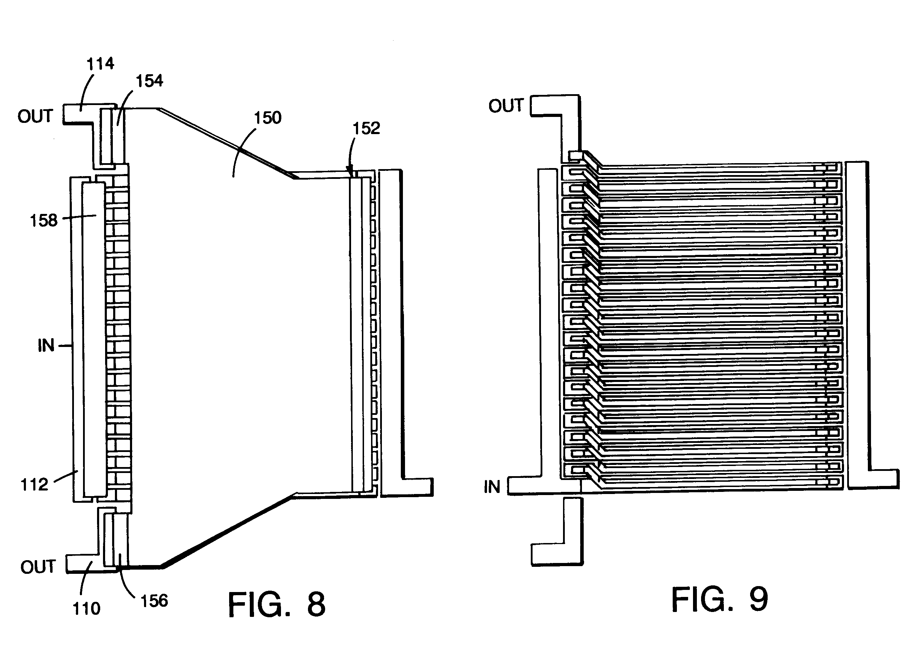

In Fig. 5, a 4 turn winding has four conductors 136 each wide enough to span five conductive runs. In Fig. 6, a 3 turn winding has two conductors 140, 142 each spanning seven conductive runs and one conductor 144 spanning six conductive runs. In Fig. 7, a 2 turn winding uses two conductors each spanning ten conductive runs. In Fig. 9, twenty conductors each span a single conductive run to form a 20 turn winding.

Referring to Fig. 8, to form a 1 turn winding, a single conductor 150 spans all twenty conductive runs. One end 152 of the conductor is connected to the connection pads of all twenty conductive runs. The other end broadens to form two legs 154 connected respectively to conductive runs 114, and 110, which carry current out of the winding. A bridge 158 connects all of the connection pads on the left ends of the conductive runs to conductive run 112 to provide a path for current into the winding.

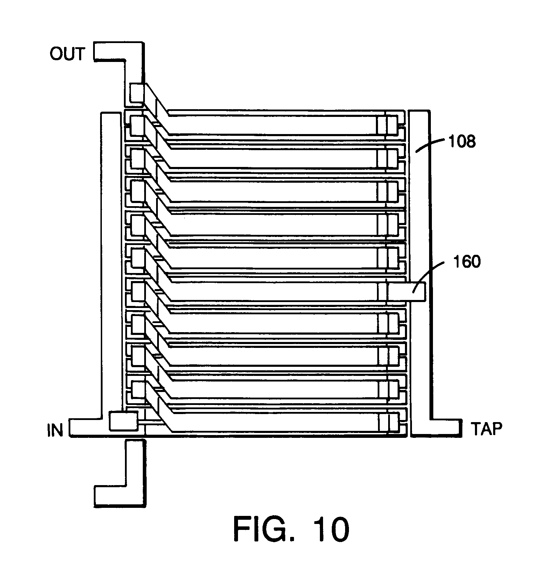

Referring to Fig. 10, a tap conductive run 108 can be connected by a bridge 160 to one of the conductors as shown to provide a tap connection to the winding.

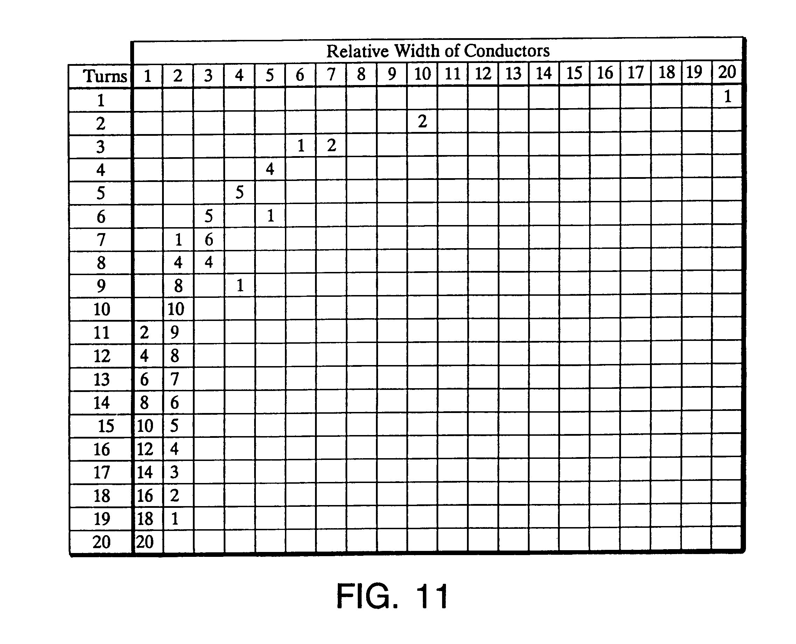

Referring to Fig. 11, any number of desired turns from 1 to 20 can be made by an appropriate choice of the number and widths of conductors to be connected to the fixed pattern of conductive runs. The chart of Fig. 11 assumes that all of the conductive runs are used. The conductors are all of equal widths for 1, 2, 4, 5, 10, and 20 turn windings; for other windings, conductors of two widths are used. For certain windings, e.g., those less than 9 turns, there are additional alternatives not listed in the chart. For example, an 8 turn winding could also be formed using four "4-wide" conductors and four "1-wide" conductors. Windings could also be formed by using fewer than the total number of conductive runs. For example a 15 turn winding could be made by using 15 "1-wide" conductors and only 15 of the conductive runs; a bridge would connect the end of the winding to a conductive run for carrying current. If two windings are formed to make a transformer, and each winding is based on a pattern of 20 conductive runs, it is clear that there are then 20 * 20 = 400 possible turns ratios that can be made, from 1:20 through 20:1.

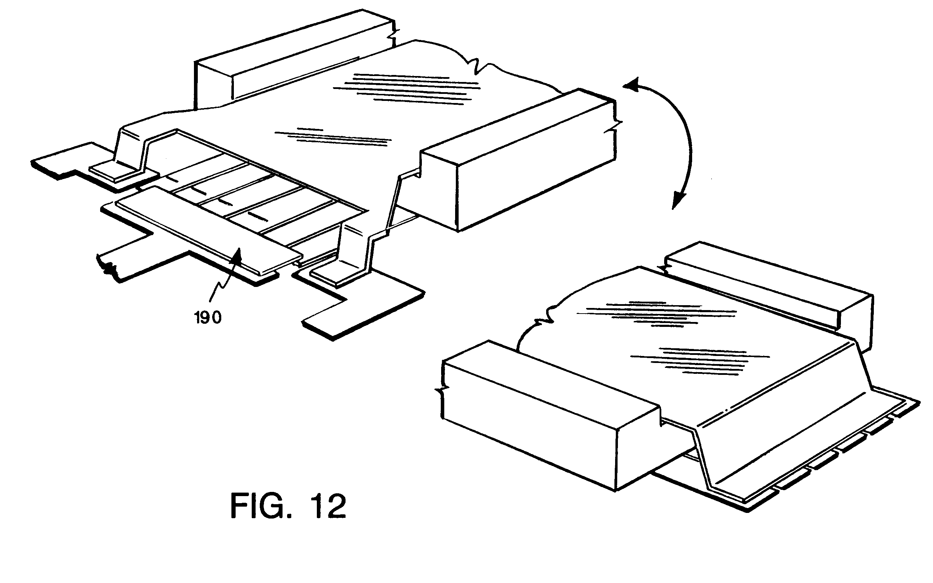

Referring to Fig. 12, it is apparent that a bridge 190 allows for large area winding terminations which are useful for windings with small numbers of turns. The bridges are also useful in windings that use fewer than all of the conductive runs. For example, a 17 turn winding can be implemented by using 17 "1-wide" conductors, 17 conductive runs, and a bridge connection from the 17th run to the input or output conductive run. Three of the conductive runs would then remain unused.

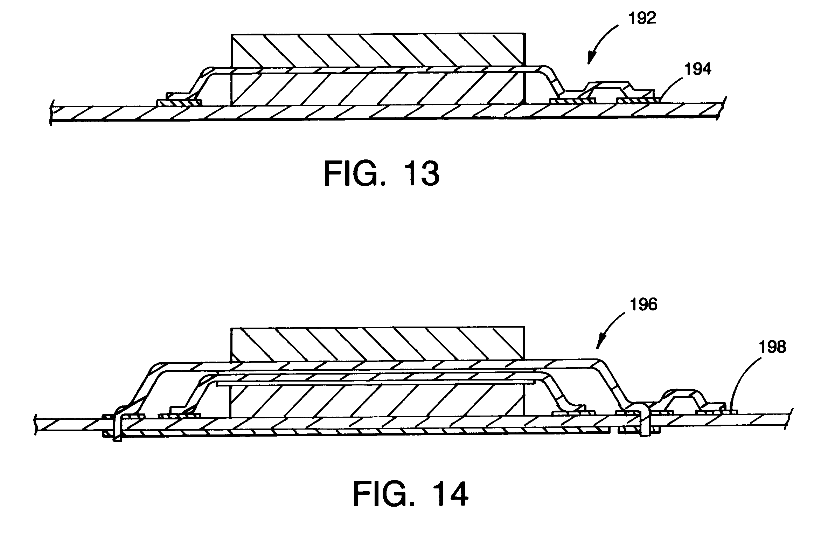

Referring to Fig. 13, it is also apparent how taps can be formed by increasing the length of the end 192 of a conductor so that it connects to another conductive run 194 on the substrate.

Referring to Fig. 14, in the case of a transformer, a tap can be formed on the upper winding by similarly extending the end 196 of a conductor to reach a separate conductive run 198 on the substrate.

From the preceding discussion, it should also be apparent that, through the use of bridges and taps and a suitable fixed pattern of conductive runs on the substrate, two or more independent windings can be formed from a single row of conductors. For example, twenty equal width conductors combined with a pattern of twenty conductive runs could be used to form two independent ten-turn windings; a seventeen-turn and a three-turn winding; or three six-turn windings (in this case, two of the conductors would not be used). By varying the widths of individual conductors within the row, and connecting the ends of appropriate conductors to termination pads which form part of the pattern of conductive turns (by means of bridges or tap connections), many possible combinations of independent windings may be formed. The only restriction is that the sum of the turns formed by the various windings cannot be greater than the number of conductive runs to which the row of conductors is attached.

It should be apparent that a multiple layer substrate, having more than two conductive layers, with a pattern of conductive runs on each layer (connections to the inner layers being made through use of plated-through holes) would allow worming one or more windings out of more than two rows of conductors, each row of conductors being overlaid upon the other. Transformers having multiple windings or high turns ratios, or inductors having large numbers of turns can be formed in this way.

During fabrication of successive windings for use on a series of printed circuit boards, each winding can be formed with any number of turns selected from among the set of possible numbers of turns. The number and configuration of the required conductors are determined from the selected number of turns and from the pattern of conductive runs and pads on the printed circuit board, as indicated above.

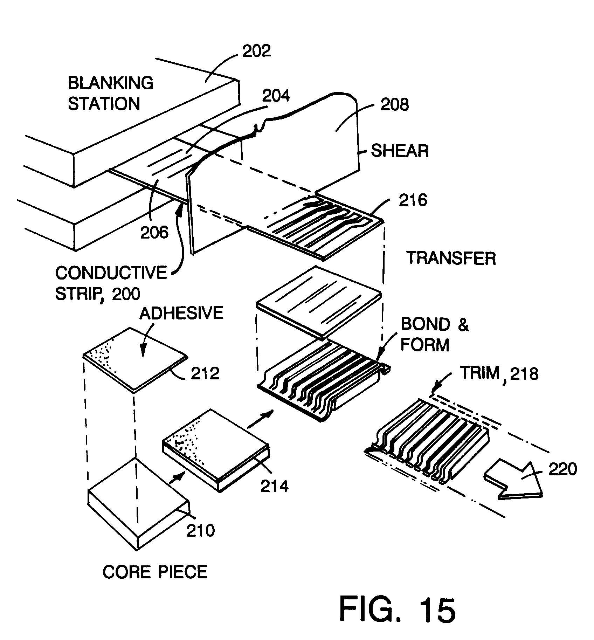

Referring to Fig. 15, in fabricating a winding, the conductors are created in "real time", i.e., at the time they are required for use in the particular winding to be installed on a printed circuit board on an assembly line. The conductors are formed on a continuous stock of flat conductive (e.g., copper-or brass) strip 200, by laser cutting the strip in a blanking station 202 to create a pattern of the required conductors 204 together with supporting areas 206 to hold the conductors in proper orientation during the initial stages of fabrication. The laser cutter may be controlled by a computer to permit lot of one fabrication of patterns.

Once the pattern for the secondary winding has been cut, the piece is severed from the strip of stock by a shear 208. Separately, a core piece 210 is coated with adhesive 212, and the coated piece 214 is delivered to a position in which the patterned piece 216 can be bent over coated piece 214 to its final form. The supporting areas 206 are then trimmed 218 and the assembled piece is delivered 220 to the location where it can be mounted on the pattern of conductive runs on the printed circuit board.

In the case of a transformer, before delivery to the printed circuit board, the dielectric layer is placed over the patterned piece, the patterned piece for the primary winding (formed in the same way as the secondary patterned piece) is placed over the dielectric layer, and the top magnetic core piece is overlaid on and attached to the dielectric with the legs of the Us of the two pieces aligned. The resulting subassembly is further processed by severing the supporting areas from the conductors of the primary winding. The finished subassembly is then laid over the conductive run pattern on the printed circuit board, with the ends of the conductors of the two windings overlaid on the connection pads of the corresponding conductive runs. (Earlier in the fabrication process, "dots" of solder paste were placed on the connection pads and the solder dots now rest between the flat surfaces of the conductors and the conductive runs).

Bridge conductors could also be formed in the blanking station 202, or, alternatively, they might be separately cut to length from strip stock at another station (not shown) for placement onto the pattern of conductive runs at an appropriate stage in the assembly process.

At a later stage in the assembly line (possibly after other components have been mounted on the printed circuit board), the solder is reflowed, thus forming low resistance electrical connections between each conductor and the corresponding conductive run (or runs). The electrical connections exhibit low resistance because they are formed at relatively broad connection regions and thus have a relatively large cross-sectional area, and because the distance between the mating surfaces of the conductors and the connection pads are small due to the precision with which the parts can be manufactured. As a result, the windings have relatively low total resistance and are thus suitable both for signal applications and power applications.

The fabrication sequence for other kinds of electromagnetic components could be similar, with differences in, for example, the number of windings that are formed and the number and configurations of the core pieces.

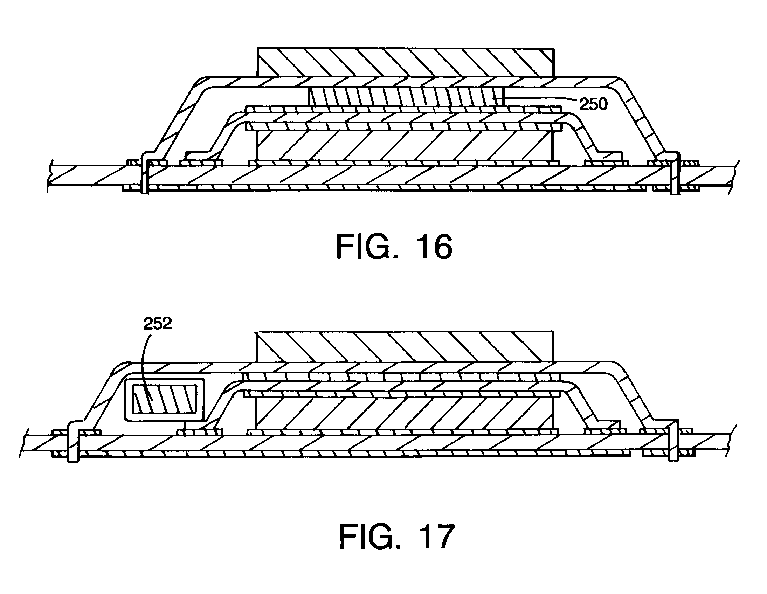

As for any magnetic structure, the windings of the electromagnetic component will exhibit values of self-inductance and leakage inductance which are dependent on the physical size and geometry of the magnetic core pieces and the windings; the spatial relationship between the magnetic core pieces and the windings; the number of turns on the windings; and the magnetic characteristics of the core pieces. The magnetic core pieces may be configured to provide a gap 72 (Fig. 1) in the magnetic circuit. One simple way of providing a carefully controlled gap is to insert a non-magnetic shim of appropriate thickness between the two core pieces. Leakage inductance, which accounts for flux generated in a winding which does not couple into other windings (and which may be useful, for example, in power converter circuits of the kind shown in Vinciarelli, United States Patent 4,415,959, incorporated by reference), can be augmented through use of flux-shunts which can be sandwiched between windings and core pieces (one example of which is shown at 250 in Fig. 16), or which can be placed in proximity to the conductors after they exit from the core (one example of which is shown at 252 in Fig. 17).

Other embodiments are feasible.

For example, a discrete electromagnetic component could be formed using a substrate and conductors and without other circuit elements mounted on the substrate.

The specific steps in the fabrication process could vary, as could their sequence. For example, the insulating layer could be wound around one or more of the winding patterns prior to the winding pattern being placed onto the component; the supporting areas for one or more of the conductive strips could be severed just after the strip was placed upon the component; different parts could be attached to other parts during the fabrication process using adhesive to ensure correct alignment. The sheet metal work piece could be, for example, die cut instead of laser cut.

The conductors could be- individually formed from strip stock, or formed on printed circuit boards with appropriate terminations. Conductive epoxy, or another conductive joint compound, might be used instead of solder, or another method of forming the conductive joints might be used, such as welding. The magnetic core pieces need not be U-shaped.

## Claims

1. An electromagnetic winding structure comprising a winding comprising

conductive runs formed on a substrate to serve as one portion of the winding, and

conductors connected to said conductive runs to serve as another portion of said winding,

said conductors and said conductive runs being electrically connected to form said winding, an end of at least one of said conductors being connected to at least two of said conductive runs.

2. A winding structure according to Claim 1, further characterised in that said conductors have a cross-section with an aspect ratio higher than 2.

3. An electromagnetic winding structure comprising a winding comprising

conductive runs formed on a substrate to serve as one portion of the winding, and

at least two conductors electrically connected to said conductive runs to serve as another portion of said winding,

said conductors having a cross-section with an aspect ratio higher than 2.

4. A winding structure according to Claim 3, further characterised in that said conductors have a cross-section which is substantially rectangular.

5. A winding structure according to any preceding claim, further characterised in that said substrate comprises a printed circuit board and said runs are formed on a surface of said board.

6. A winding structure according to any preceding claim, further characterised in that said substrate comprises plated-through holes connected to said conductive runs, and at least some of said conductors are electrically connected to said conductive runs via said plated-through holes.

7. A winding structure according to any preceding claim, further characterised in comprising a second winding comprising additional conductors overlaid on the first said conductors.

8. A winding structure according to any preceding claim, further characterised in that said conductive runs are arranged in parallel on said substrate.

9. A winding structure according to any preceding claim, further characterised in that the number of said conductive runs on said substrate is a non-prime number.

10. A winding structure according Claim 9, further characterised in that said non-prime number is divisible by at least two integers other than one and the non-prime number itself, and is preferably 20.

11. A winding structure according to any preceding claim, further characterised in that said substrate is generally planar and said conductive runs comprise two sets lying respectively on opposite sides of said substrate.

12. A winding structure according to any preceding claim, further characterised in comprising a magnetic core structure magnetically coupled to said winding.

13. A winding structure according to Claim 12, further characterised in that said magnetic core structure comprises a magnetic core piece surrounded by said winding.

14. A winding structure according to Claim 13, further characterised in that said magnetic core structure further comprises an additional magnetic core piece which cooperates with the first said magnetic core piece to form a magnetic flux circuit with one segment of said magnetic circuit lying within said winding and the another segment of said magnetic circuit lying outside said winding.

15. A winding structure according to Claim 14, further characterised in that said magnetic flux circuit includes a predefined gap.

16. A winding structure according to any preceding claim, further characterised in that an end of one of said conductors is connected to more than two of said conductive runs.

17. A winding structure according to any of Claims 1 to 15, further characterised in that different said conductors are connected respectively to different numbers of said conductive runs.

18. A winding structure according to any preceding claim, further characterised in that one of said conductive runs is not connected in said winding and in that a bridge connects at least one of the conductive runs which is connected to said winding to a termination conductive run on said substrate.

19. A winding structure according to any of Claims 1 to 17, further characterised in comprising a termination conductive run for carrying current to or from said winding, and a bridge for connecting one of said conductive runs to said termination conductive run.

20. A winding structure according to Claim 19, further characterised in that said bridge connects multiple said conductive runs to said termination conductive run.

21. A winding structure according to Claim 19, characterised in further comprising a bridge for connecting at least one of the conductive runs which is connected in said winding to a termination conductive run on said substrate.

22. A winding structure according to any of Claims 1 to 17, characterised in further comprising a tap conductive run for carrying current to or from a tap of said winding, and a bridge for connecting one of said conductive runs to said tap conductive run.

23. A winding structure according to any of Claims 1 to 4, further characterised in that said substrate is generally planar and has more than two layers, and in that said conductive runs comprise more than two sets lying respectively on different layers of said substrate.

24. A free-standing, discrete structure for use in an electromagnetic winding comprising
 a magnetic core piece, and
 at least two conductors overlaid upon and in parallel to said magnetic core piece with ends of said conductors forming flat connection regions arrayed for attachment to a corresponding array of connection pads on a substrate.

25. A structure according to Claim 24, further characterised in that said flat conductors are arranged in parallel.

26. A structure according to Claims 24 or 25, further characterised in that said conductors have portions which are in contact with said magnetic core piece, and free ends which are not in contact with said magnetic core piece, said free ends forming said flat connection regions.

27. A structure according to any of Claims 24, 25 or 26, further characterised in that said conductors comprise two sets of conductors, one set overlying the other.

28. A structure according to any of Claims 24 to 27, characterised in further comprising a second magnetic core piece arranged to form, with the first said magnetic core piece, a channel in which at least portions of said conductors lie.

29. A structure according to Claim 28, further characterised in that the first said magnetic core piece and the second said magnetic core piece form a magnetic circuit.

30. A structure according to Claim 29, further characterised in that said magnetic circuit comprises a predetermined gap.

31. A structure according to any of Claims 24 to 30, further characterised in that said magnetic core piece is essentially U-shaped.

32. A transformer comprising a pair of windings, each winding comprising
 conductive runs formed on a substrate to serve as one portion of the winding, and
 conductors connected to said conductive runs to serve as another portion of said winding,
 said conductors and said conductive runs being electrically connected to form said winding,
 an end of at least one of said conductors of one of said windings being connected to at least two of said conductive runs of said one winding.

33. The transformer of claim 32, further comprising a magnetic core defining a magnetic circuit, said windings and said magnetic circuit being electromagnetically coupled.

34. A method of forming an electromagnetic winding comprising
 forming conductive runs on a substrate to serve as one portion of said winding,
 removing portions of a flat conductive work piece to form a pattern of flat conductors to serve as another portion of said winding, and
 forming electrical connections between portions of said flat conductors and portions of said conductive runs to form said winding.

35. The method of claim 34, wherein said flat conductive work piece comprises a metal sheet large enough form more than one said pattern.

36. The method of claims 34 or 35, further comprising forming supporting regions on said flat conductive work piece to hold said conductors in place.

37. The method of claim 34 further comprising attaching said pattern of flat conductors to a magnetic core before forming said electrical connections.

38. The method of claim 36, comprising removing said supporting regions prior to forming said electrical connections.

39. The method of any of Claims 34 to 38, wherein said portions of said flat conductive work piece are removed by laser cutting.

40. The method of any of Claims 34 to 38, wherein said portions of said flat conductive work piece are removed by die cutting.

41. A method of forming a free-standing, discrete electromagnetic structure for use in an electromagnetic winding, comprising

providing a magnetic core piece, and

attaching conductors in parallel to said magnetic core piece with ends of said conductors forming flat connection regions arrayed for attachment to a corresponding array of connection pads on a substrate.

42. A method of manufacturing a series of similar versions of an electrical circuit, said electrical circuit including an electromagnetic component having at least one winding, different versions of said electrical circuit incorporating different versions of said electromagnetic component having respectively different numbers of turns in said winding, said method comprising

providing identical copies of a printed circuit board corresponding to said electrical circuit, each copy of said printed circuit board having a region of conductive runs for serving as a portion of said winding,

mounting electrical components on each said printed circuit board at stations along an assembly line,

while a particular said printed circuit board is on said assembly line, fabricating a set of high-aspect-ratio conductors to serve as another portion of said winding, the number of said conductors depending on the number of turns required in the winding needed for said electromagnetic component for said particular printed circuit board, and

at a station along said assembly line, connecting said conductors to said conductive runs to form said electromechanical component.

43. The method of claim 42, wherein said high-aspect-ratio conductors are fabricated by cutting a work piece by means of a computer controlled cutter.

44. A method of forming, on each one of a series of printed circuit boards, an electromagnetic component having a winding, the method comprising

forming identical patterns of conductive runs on said different boards, and

electrically connecting to the pattern on each of said boards, in order to form a winding, a set of conductors which in number and configuration cause said winding to have a selected number of turns,

the windings of said electromagnetic components on different ones of said boards having different, selected numbers of turns.

FIG. 1

FIG. 3

FIG. 2

FIG. 5

FIG. 4

OUT

IN

FIG. 7

144

142

140

OUT

IN

FIG. 6

FIG. 8

FIG. 9

EP 0 481 755 A2

FIG. 10

| Turns | Relative Width of Conductors | | | | | | | | | | | | | | | | | | | |
|---|---|---|---|---|---|---|---|---|---|---|---|---|---|---|---|---|---|---|---|---|
| | 1 | 2 | 3 | 4 | 5 | 6 | 7 | 8 | 9 | 10 | 11 | 12 | 13 | 14 | 15 | 16 | 17 | 18 | 19 | 20 |
| 1 | | | | | | | | | | | | | | | | | | | | 1 |
| 2 | | | | | | | | | | 2 | | | | | | | | | | |
| 3 | | | | | | 1 | 2 | | | | | | | | | | | | | |
| 4 | | | | | 4 | | | | | | | | | | | | | | | |
| 5 | | | | 5 | | | | | | | | | | | | | | | | |
| 6 | | | 5 | | 1 | | | | | | | | | | | | | | | |
| 7 | | 1 | 6 | | | | | | | | | | | | | | | | | |
| 8 | | 4 | 4 | | | | | | | | | | | | | | | | | |
| 9 | | 8 | | 1 | | | | | | | | | | | | | | | | |
| 10 | | 10 | | | | | | | | | | | | | | | | | | |
| 11 | 2 | 9 | | | | | | | | | | | | | | | | | | |
| 12 | 4 | 8 | | | | | | | | | | | | | | | | | | |
| 13 | 6 | 7 | | | | | | | | | | | | | | | | | | |
| 14 | 8 | 6 | | | | | | | | | | | | | | | | | | |
| 15 | 10 | 5 | | | | | | | | | | | | | | | | | | |
| 16 | 12 | 4 | | | | | | | | | | | | | | | | | | |
| 17 | 14 | 3 | | | | | | | | | | | | | | | | | | |
| 18 | 16 | 2 | | | | | | | | | | | | | | | | | | |
| 19 | 18 | 1 | | | | | | | | | | | | | | | | | | |
| 20 | 20 | | | | | | | | | | | | | | | | | | | |

FIG. 11

FIG. 12

**FIG. 13**

**FIG. 14**

EP 0 481 755 A2

FIG. 15

FIG. 16

FIG. 17